## Europäisches Patentamt
## European Patent Office
## Office européen des brevets

(19)

(11) Publication number: **0 016 577**
**B1**

(12)

# EUROPEAN PATENT SPECIFICATION

(45) Date of publication of patent specification: **13.04.83**

(51) Int. Cl.³: **H 01 L 23/52,**
**H 01 L 29/62, H 01 L 29/60**

(21) Application number: **80300661.8**

(22) Date of filing: **05.03.80**

(54) **Semiconductor integrated circuit device with a double interconnection layer.**

(30) Priority: **09.03.79 JP 27361/79**

(43) Date of publication of application:
**01.10.80 Bulletin 80/20**

(45) Publication of the grant of the patent:
**13.04.83 Bulletin 83/15**

(84) Designated Contracting States:
**DE FR GB**

(56) References cited:
**DE - A - 2 814 973**

(73) Proprietor: **TOKYO SHIBAURA DENKI KABUSHIKI KAISHA**
**72, Horikawa-cho Saiwai-ku**
**Kawasaki-shi Kanagawa-ken 210 (JP)**

(72) Inventor: **Asano, Masamichi**
**2-24-12, Naka-cho**
**Musashino-shi Tokyo (JP)**
Inventor: **Iwahashi, Hiroshi**
**1-7-7 Kaminomiya, Tsurumi-ku**
**Yokohama-shi, Kanagawa-ken (JP)**

(74) Representative: **Eyles, Christopher Thomas**
**BATCHELLOR, KIRK & EYLES 2 Pear Tree Court**
**Farringdon Road**
**London, EC1R 0DS (GB)**

## Semiconductor integrated circuit device with a double interconnection layer

This invention relates to a semiconductor insulated circuit device comprising a semiconductor substrate on which an insulation layer is formed, a first wiring layer formed of semiconductive material and positioned on said insulation layer, and a second wiring layer formed of semiconductive material, formed over said first semiconductor layer.

Interconnections have been formed in prior semiconductor integrated circuit device by means of metal layers diffusion regions formed in the semiconductive substrate, polycrystalline silicon layers and so on. Generally, the resistance value of the interconnection means or "wiring layers" is preferred to be smaller, so metal layers for example aluminium layers are preferred. However, when the semiconductor integrated circuit is constructed in high density form, the interconnections cannot be formed by a single metal layer, because it may be necessary for several wiring layers to cross at one point. In such a case one layer may comprise for example a polycrystalline silicon layer as a wiring means at the crossing point, whilst a second wiring layer made of metal is formed over the first wiring layer with an insulating layer interleaved between the two layers. Using this technique, it is easy to produce a semiconductive integrated circuit which includes crossing points of the wiring layers. Further, the polycrystalline silicon layer may be used as the electrode of a metal oxide semiconductor field effect transistor (hereinafter called MOS FET). When the gate electrode is constructed with polycrystalline silicon material, the MOS FET can be manufactured by a self-alignment process so that it will be formed compactly, and its operating characteristics will be improved.

Thus recently polycrystalline silicon has frequently been used to form the wiring layers and electrodes. However, the sheet resistance of the polycrystalline silicon is very high and so doped polycrystalline has come to be used instead, and has a sheet resistance of the order of several tens of $\Omega/\square$.

The sheet resistance can be lowered by increasing the level of doping, but as the doping level increases it becomes more difficult to control the etching process. Thus the quantity of impurity which can be introduced into the polycrystalline silicon as dopant is restricted by the precision of the etching process, so the most commonly used form of doped polycrystalline silicon has a sheet resistance of about 40 $\Omega/\square$ to 50 $\Omega/\square$, which is much higher than that of metal layers for example aluminium layers, so the operating speed and flexibility of design of the circuit will be limited.

Another method of decreasing the resistance of the polycrystalline silicon layer is to increase its thickness and width. However this can give rise to the disadvantage that the aluminium layer thereover may be pierced by the sharp edge of the thick polycrystalline silicon layer, and the increase of width will result in increasing the total area of the device.

The present invention seeks to provide a semiconductor integrated circuit device which can be constructed in high density form and which can operate at high speed.

A semiconductor integrated circuit device is already known from DE—A—2814973, which comprises a semiconductor substrate, an insulation layer formed on the substrate, a first wiring layer formed of semiconductive material and positioned on the said insulation layer, and a second wiring layer, also formed of semiconductive material and formed over the first semiconductive layer.

This specification also discloses an arrangement including a third insulation layer formed on the second wiring layer, and a conductive layer positioned on the said third insulation layer, and arrangements in which either the first wiring layer, or the second wiring layer, form the gate electrode of a field effect transistor which is formed in the semiconductive substrate.

The present invention also seeks to provide a semiconductor integrated circuit device of this type which includes wiring layers whose resistance is kept low.

According to one aspect of the present invention there is provided a semiconductor integrated circuit device comprising semiconductor substrate on which an insulation layer is formed, a first wiring layer formed of semiconductive material and positioned on said insulation layer, and a second wiring layer formed of semiconductive material, formed over said first semiconductor layer, characterised in that said second wiring layer is electrically connected in parallel with said first wiring layer.

One embodiment of the invention comprises a semiconductor integrated circuit device including a semiconductor substrate on which an insulation layer is formed, a first wiring layer formed of semiconductive material and positioned on said insulation layer, and adapted to operate as a gate electrode of a MOS FET, and a second wiring layer formed of semiconductive material, and being connected in parallel to said first layer so as to decrease the total resistance.

Some embodiments of the invention will now be described by way of example with reference to the accompanying drawings, wherein:

Figure 1 is a partial plan view of one embodiment of this invention.

Figure 2 is a vertical cross-section on line II—II of Figure 1,

Figure 3 is a partial plan view of another embodiment of this invention,

Figure 4 is a vertical cross-section on line IV—IV of Figure 3

Figure 5 is a partial plan view of another embodiment of this invention,

Figure 6 is a vertical cross-section on line VI—VI of Figure 5; and

Figure 7 is a vertical cross-section on line VII—VII of Figure 5.

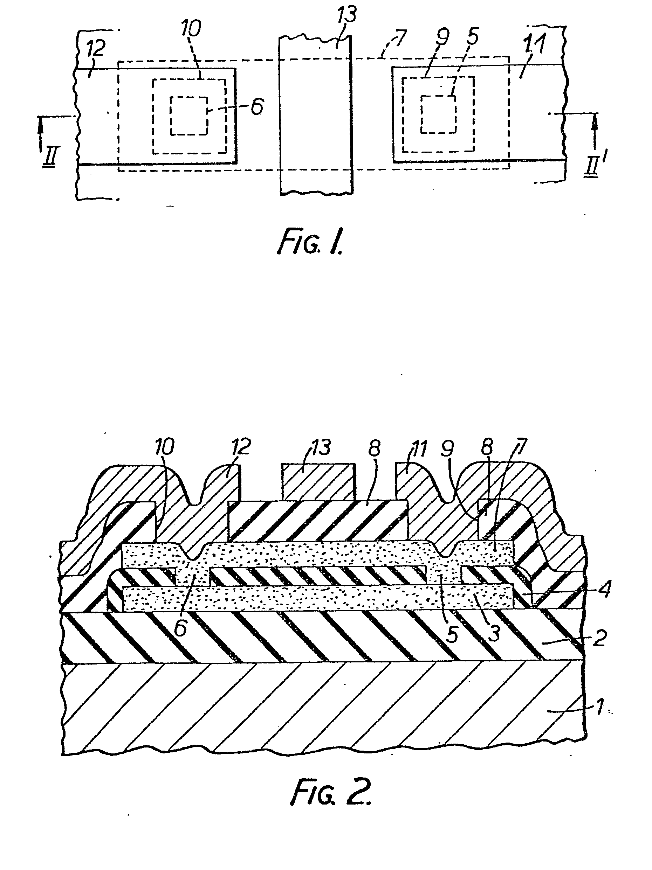

Referring now to the drawings, wherein like reference numerals designate identical of corresponding parts throughout the several views, and more particularly to Figures 1 and 2 thereof, one embodiment of the semiconductor integrated circuit device of this invention is illustrated. In Figure 1 and Figure 2, on the upper surface of the n-type semiconductor substrate (1) is provided an insulation layer (2). The substrate (1) is of silicon (Si) and the layer (2) is made of silicon oxide ($SiO_2$). The insulation layer (2) has a thickness of about seven or eight thousand angstroms (700—800 nm) and is formed by chemical vapour deposition technique, and the polycrystalline silicon layer (3) covers selected portions thereof with a thickness of about three hundred nm. Initially the polycrystalline silicon layer (3) is formed to cover the whole surface of the insulation layer (2), and subsequently it is partially etched away by a photo-engraving process. The addition of an impurity, such as phosphorus, boron, or the like, to the polycrystalline silicon layer (3), reduces its sheet resistance to about 40 $\Omega/\square$. The surface of the polycrystalline silicon layer (3) is then oxidized using a thermal oxidation process to form a silicon oxide layer (4). The silicon oxide layer (4) has a thickness of about one hundred nm, and has two contact holes (5) and (6). The holes (5) and (6) are formed by the photo-engraving process. Thereafter a second polycrystalline silicon layer (7) is formed over the silicon oxide layer (4) with a thickness of about three of four hundred nm and makes contact with the first polycrystalline silicon layer (3) through the contact holes (5) and (6). The second polycrystalline silicon layer (7) is formed in substantially the same pattern as the first polycrystalline silicon layer (3) and operates as the main wiring layer. An insulation (8) is formed to cover them. The insulation layer (8) is made of silicon oxide and has a thickness of 1.3 micron. In this embodiment, the insulation layer (8) is formed by a chemical vapour deposition technique. After the covering process, two contact holes (9) and (10) are formed by photo engraving process. Through the two contact holes (9) and (10), aluminium layers (11) and (12) applied over selected portions of the insulator layer (8) make contact with the second polycrystalline silicon layer (7). The aluminium layers (11) and (12) are connected through the polycrystalline silicon layers (3) and (7) to circuit elements formed on the substrate. Further, the aluminium layer (13) positioned on the insulator layer (8) crosses over the first and second polycrystalline silicon layers (3) and (7). As the aluminium layers (11) and (12) and the polycrystalline silicon layers (3) and (7) operate together as wiring layers, their total resistance is low. The resistance of the aluminium is very low, but that of the polycrystalline silicon is higher than the aluminium. Therefore the polycrystalline silicon layers (3) and (7) are connected in parallel, so that their resistance is about one half of that of one polycrystalline silicon layer alone. Further, as the change in level at the edge of the two polycrystalline silicon layers is made less abrupt by the existence of the silicon oxide layer (4), the aluminium layers (11) and (12) will not be pierced by the edge. In order to further reduce the abruptness of the change of level, the layer 7 can be made slightly smaller so that its edge does not coincide with that of layer 4.

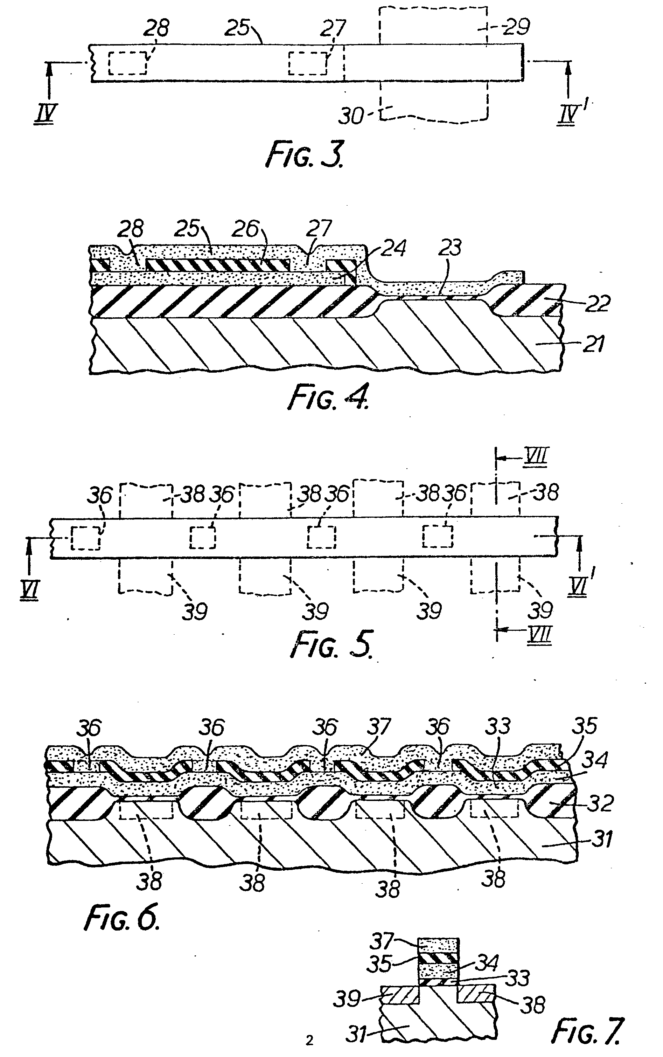

Figures 3 and 4 show a second embodiment of this invention. On a P type semiconductive substrate (21), a thick film silicon oxide layer (22) is formed by using a selective oxidation process. Next, the first polycrystalline silicon layer (24) is formed on the selected position of the silicon oxide layer (22). This layer (24) operates as the secondary wiring layer for a further polycrystalline silicon layer (25) formed thereover.

The polycrystalline silicon layers (24) and (25) become conductive by doping with an impurity such as phosphorus, boron or the like. The polycrystalline silicon layer (24) is covered by a silicon oxide layer (26). The silicon oxide layer (26) has two contact holes (27) and (28) formed by a photo-engraving process and is formed by thermal oxidation of the surface of the polycrystalline silicon layer (24). A silicon oxide layer (23) forming the gate of a MOS FET and having a thickness of one hundred nm, formed at the same time, simplifying the manufacturing process. The second polycrystalline silicon layer (25) is then formed over the layer 26 and the exposed portions of layers 22 and 24. The polycrystalline silicon layer (25) thus operates as the gate electrode of the MOS FET and as a wiring layer, being connected in parallel with the first polycrystalline silicon layer (24) through the two contact holes (27) and (28) in order to decrease the resistance. The source region (29) and the drain region (30) of the MOS FET are formed in the substrate (21) by diffusing phosphorus as an N-type impurity using the gate silicon oxide layer (23) and the polycrystalline silicon layer (25) as a mask.

Figures 5 and 6 show the third embodiment of this invention. In this embodiment, a plurality of MOS FETs are regularly arranged in the semiconductor substrate (31), and constitute a memory array. They are formed in the following way:

A thick film silicon oxide layer (32) is formed on the selected portion of the p-type semiconductor substrate (31) by using a selective oxidation process. The thickness thereof is about seven or eight hundred nm. Next, the gate silicon oxide layer (33) of the MOS FETs is formed using a thermal oxidation process. The thickness thereof is of about one hundred nm. After that, the first polycrystalline silicon layer (34) operating both as a set of gate electrodes and as a wiring layer, is formed on the selective portion of the silicon oxide layers (32) and (33). The first polycrystalline silicon layer (34) is then covered by silicon oxide layer (35). The silicon oxide layer (35) has contact holes (36) and is formed by thermal oxidation of the first polycrystalline silicon layer (34). Then, the second crystalline layer (37) is formed over the first polycrystalline silicon layer (34) in order to decrease the resistance of the wiring layer. These two layers (34) and (37) are connected through the holes (36). The polycrystalline silicon layers (34) and (37) are made conductive by doping with a suitable impurity.

Next the silicon oxide layer (35), the first polycrystalline silicon layer (34) and the gate silicon oxide layer (33) are etched using the second polycrystalline silicon layer (37) over the channel region of the MOS FETs as the mask so as to leave suitable portions positioned over the channel region of MOS FET to form masks for forming the source and drain regions. In this way these layers (33), (34) and (35) will be formed with the same width as the second polycrystalline silicon layer (37).

Thereafter, an n-type impurity is doped into the p-type substrate (31), and the source regions (38) and the drain regions (39) are formed therein. In this way, as the layers (33), (34), (35) and (37) with the same width are used as the mask, the length between source and drain regions (38) and (39) is equal to the width of the layers (34) and (37), (see Figure 7) so the electric field of the gate electrode (34) and (37) will be uniformly applied to the channel region. This method of construction, avoids the possibility of the layer (37) being formed out of register with the layer (34), which could cause the length of the channel region to be non-uniform because of the gap between the two layers (34) and (37), so that the electric field of the gate electrodes (34) and (37) would become non-uniform and the characteristics of the MOS FETs would become inferior.

According to this embodiment of the invention the channel length of MOS FET is made more uniform and the resistance of the wiring layer and the gate electrode is kept very low, so that the circuit will be able to operate at high speed and the whole device will be of compact construction and have superior electrical characteristics.

The connection between the first and second polycrystalline silicon layers can be accomplished by a greater number of contact holes or they may be laminated directly on one another. Then the connecting resistance may be made smaller, but the positioning of two layers and the whole process will become more critical, because the wiring pattern is generally very complicated. Another possibility is that the contact holes for connecting the two layers can be formed at the same time that the direct contact holes, connecting the polycrystalline silicon layer and the diffusion layer in the substrate, are formed. Then the process will be simplified. Further, the thermal oxidation process can be substituted by a chemical vapour deposition process, and a predoped polycrystalline silicon layer may be used instead of doping impurity into the polycrystalline layer during the manufacturing process.

**Claims**

1. A semiconductor integrated circuit device comprising:

a semiconductor substrate (1) on which an insulation layer (2) is formed;

a first wiring layer (3) formed of semiconductive material and positioned on said insulation layer; and

a second wiring layer (7) formed of semiconductive material, formed over said first semiconducting layer, characterised in that said second wiring layer is electrically connected in parallel with said first wiring layer.

2. A semiconductor integrated circuit device according to claim 1 wherein the first wiring layer is covered by a second insulation layer (4) which has at least two contact holes (5, 6).

3. A semiconductor integrated circuit device according to claim 2 which comprises a third insulation layer (8) formed on the second wiring layer (7) and a conductive layer (11, 12) positioned on said third insulation layer.

4. A semiconductor integrated circuit device according to claim 3 wherein the first wiring layer (3) forms the gate electrode of a field effect transistor which is formed in the semiconductor substrate.

5. A semiconductor integrated circuit device according to claim 3 wherein the second wiring layer (25) is operated as a gate electrode of a field effect transistor which is formed in the semiconductor substrate (Figure 4).

6. A semiconductor integrated circuit device according to claim 3 wherein the first wiring layer (3) has substantially the same configuration as the second wiring layer (7).

7. A semiconductor integrated circuit device according to claim 4 or 6 wherein;

said semiconductor substrate (31) incorporates source and drain regions (38, 39) of a plurality of field effect transistors;

and said first semiconductor wiring layer (34) forms a set of gate electrodes for said plural field effect transistors.

8. A semiconductor integrated circuit device according to claim 7, wherein the first wiring layer (34) has the same width as the second wiring layer thereover (37).

9. A semiconductor integrated circuit device according to claim 7 or 8 wherein the channel length of the plural field effect transistors is the same length as the width of the first and second semiconductor layers formed over the channel regions of the field effect transistors.

## Revendications

1. Dispositif semiconducteur à circuits intégrés qui comprend un substrat semiconducteur (1) sur lequel une couche isolante (2) a été formée, une première couche de connexion ou de câblage (3) formée d'une matière semiconductrice et placée sur ladite couche isolante et une seconde couche de connexion ou de câblage (7) faite d'une matière semiconductrice et formée au-dessus de ladite première couche semiconductrice, caractérisé en ce que ladite seconde couche de connexion ou de câblage est branchée du point de vue électrique en parallèle sur ladite première couche de connexion ou de câblage.

2. Dispositif semiconducteur à circuits intégrés selon la revendication 1, caractérisé en ce que la première couche de connexion ou ce câblage est couverte d'une seconde couche isolante (4) qui est percée d'au moins deux trous de contact (5, 6).

3. Dispositif semiconducteur à circuits intégrés selon la revendication 2, caractérisé en ce qu'il comprend une troisième couche isolante (8) formée sur la seconde couche de connexion ou de câblage (7) et une couche conductrice (11, 12) placée sur cette troisième couche isolante.

4. Dispositif semiconducteur à circuits intégrés selon la revendication 3, caractérisé en ce que la première couche de connexion ou de câblage (3) forme la porte d'un transistor à effet de champ formé dans le substrat semiconducteur.

5. Dispositif semiconducteur à circuits intégrés selon la revendication 3, caractérisé en ce que la seconde couche de câblage ou de connexion (25) joue le rôle de la porte d'un transistor à effet de champ formé sur le substrat semiconducteur (figure 4).

6. Dispositif semiconducteur à circuits intégrés selon la revendication 3, caractérisé en ce que la première couche de connexion ou de câblage (3) a sensiblement le même contour que la seconde couche de connexion ou de câblage (7).

7. Dispositif semiconducteur à circuits intégrés selon la revendication 4 ou 6, caractérisé en ce que ledit subtrat semiconducteur (31) renferme des régions de source et de drain (38, 39) d'une multiplicité de transistors à effet de champ et en que ladite première couche de connexion ou de câblage semiconductrice (34) forme un groupe de portes pour ladite multiplicité de transistors à effet de champ.

8. Dispositif semiconducteur à circuits intégrés selon la revendication 7, caractérisé en ce que la première couche de connexion ou de câblage (34) a la même largeur que la seconde couche de connexion ou de câblage (37) qui la couvre.

9. Dispositif semiconducteur à circuits intégrés selon la revendication 7 ou 8, caractérisé en ce que la longueur du canal de ladite multiplicité de transistors à effet de champ est la même que la largeur de la première et de la seconde couches semiconductrices formées au dessus des canaux des transistors à effet de champ.

## Patentansprüche

1. Integrierte Halbleiterschaltung bestehend aus:—

einer Halbleiterträgerschicht (1), auf der eine Isolationsschicht (2) aufgebracht ist;

einer ersten elektrisch leitenden Schicht (verdrahtungsschicht, Anschlußschicht ?) (3), die aus Halbleitermaterial hergestellt und auf der zuvor angeführten Isolationsschicht angeordnet ist; schließlich auch noch aus

einer zweiten elektrisch leitenden Schicht (7), die aus Halbleitermaterial hergestellt und auf der vorerwähnten ersten Halbleiterschicht angeordnet ist; dadurch gekennzeichnet, daß

daß die vorerwähnte zweite elektrisch leitende Schicht zur vorerwähnten elektrisch leitenden Schicht parallel geschaltet ist.

2. Halbleiterschaltung nach Anspruch 1, dadurch gekennzeichnet, daß

daß die erste elektrisch leitende Schicht oder Anschlußschicht mit einer zweiten Isolationsschicht (4) abgedeckt ist und daß in diese Isolationschicht (4) mindestens zwei Kontaktlöcher (5, 6) eingearbeitet sind.

3. Integrierte Halbleiterschaltung nach Anspruch 2, dadurch gekennzeichnet, daß

auf die zweite elektrisch leitende Schicht oder Anschlußschicht (7) eine dritte Isolationsschicht (8) aufgebracht ist und auf dieser wiederum eine elektrisch leitende Schicht (11, 12).

4. Integrierte Halbleiterschaltung nach Anspruch 3, dadurch gekennzeichnet, daß

von der ersten elektrisch leitenden Schicht oder Anschlußschicht der Gatt-Anschluß eines Feldeffekttransistors dargestellt ist, der seinerseits wiederum in die Halbleiterträgerschicht eingearbeitet ist.

5. Integrierte Halbleiterschaltung nach Anspruch 3, dadurch gekennzeichnet, daß,

die zweite elektrisch leitende Schicht oder Anschlußschicht (25) wie ein Gatt-Anschluß eines Feldeffekttransistors betrieben wird, der (nach Fig. 4) in die Halbleiterträgerschicht eingearbeitet ist.

6. Integrierte Halbleiterschaltung nach Anspruch 3, dadurch gekennzeichnet, daß

in der Konfiguration die erste elektrisch leitende Schicht oder Anschlußschicht (3) im wesentlichen gleich der zweiten elektrisch leitenden Schicht oder Anschlußschicht (7) ist.

7. Integrierte Halbleiterschaltung nach Anspruch 4 oder Anspruch 6, dadurch gekennzeichnet, daß

daß die angeführte Halbleiterschicht (31) Emitterbereiche und Kollektorbereiche (38, 39) von mehreren Feldeffekttransistoren aufweist; schließlich die angeführte erste elektrisch leitende Schicht oder Anschlußschicht (34) eine Gruppe von Gatt-Anschlüssen für die vorerwähnten mehreren Feldeffekttransistoren darstellt.

8. Integrierte Halbleiterschaltung nach Anspruch 7, dadurch gekennzeichnet, daß

daß die erste elektrisch leitende Schicht oder Anschlußschicht (34) die gleiche Breite wie die darüber angeordnete zweite elektrisch leitende Schicht oder Anschlußschicht (37) hat.

9. Integrierte Halbleiterschaltung nach Anspruch 7 oder Anspruch 8, dadurch gekennzeichnet, daß

die Kanallänge der mehreren Feldeffekttransistoren die gleiche Länge hat wie die Breite der über den Kanalbereichen der Feldeffekttransistoren hergestellten ersten und zweiten Halbleiterschichten.

FIG. 1.

FIG. 2.

**0016577**

Fig. 3.

Fig. 4.

Fig. 5.

Fig. 6.

Fig. 7.